Europäisches Patentamt

European Patent Office

Office européen des brevets

(11) Numéro de publication: **0 338 904**
**A1**

# (12) DEMANDE DE BREVET EUROPEEN

(21) Numéro de dépôt: **89401052.9**

(22) Date de dépôt: **17.04.89**

(51) Int. Cl.⁴: **H 01 S 3/23**
H 01 S 3/08, H 01 S 3/19

(30) Priorité: **19.04.88 FR 8805156**

(43) Date de publication de la demande:
**25.10.89 Bulletin 89/43**

(84) Etats contractants désignés:
**AT BE CH DE ES FR GB GR IT LI LU NL SE**

(71) Demandeur: **BERTIN & CIE SOCIETE ANONYME**
**59, rue Pierre Curie**
**F-78370 Plaisir (FR)**

(72) Inventeur: **Sansonetti, Pierre**
**Les Vignes de Marius Jas de Bouffan Bt 4**
**F-13090 Aix En Provence (FR)**

(74) Mandataire: **Mongrédien, André et al**
**c/o SOCIETE DE PROTECTION DES INVENTIONS 25, rue**
**de Ponthieu**
**F-75008 Paris (FR)**

(54) **Procédé et dispositif pour améliorer la directivité de l'émission d'une diode laser solide.**

(57) Procédé et dispositif pour améliorer l'efficacité de conversion et la directivité de l'émission d'une diode laser solide.

Le dispositif de l'invention comprend essentiellement une cavité externe (18) couplée à la face intracavité (16) de la diode laser (10) semi-conductrice à rubans multiples (12), via un réseau de déphasage (20) engendrant un déphasage de π entre chaque ruban. Cette cavité est fermée par des moyens de réflexion partielle et localisée tels qu'un filtre spatial (42) et un miroir semiréfléchissant (44) agencés pour ne réfléchir que le mode fondamental de la diode et permettre ainsi une émission monolobe axiale.

FIG.1

## Description

### Procédé et dispositif pour améliorer la directivité de l'émission d'une diode laser solide

L'invention a pour objet un procédé et un dispositif pour améliorer l'efficacité de conversion et la directivité de l'émission d'une diode laser solide du type à rubans multiples. Elle trouve une application dans le domaine des télécommunications optiques.

Les diodes lasers à semi-conducteurs sont des sources optiques très intéressantes pour leur fort rendement de conversion électronique/optique. Cependant, les diodes classiques à simple ruban sont limitées à des puissances optiques émises de l'ordre de quelques dizaines de mW à cause de la dégradation de leurs faces clivées.

Pour pallier à ce problème, des diodes lasers ayant plusieurs rubans couplés ont été développées pour obtenir une émission cohérente intense avec une puissance moindre au niveau des faces clivées. Ces diodes lasers sont cependant intrinsèquement multimodes et possèdent donc des caractéristiques dégradées ; le diagramme d'émission en champ lointain est par exemple formé de plusieurs lobes situés hors de l'axe optique, leur répartition dépendant du courant d'injection.

Par ailleurs, si l'on utilise de façon connue un ruban large pour obtenir une forte puissance optique, des phénomènes thermiques, des filaments lasers instables ainsi que des variations de densité de porteurs le long de la couche active posent des problèmes.

Dans les diodes lasers à plusieurs rubans couplés, plusieurs solutions ont été développées pour coupler ces rubans en phase : par la diffraction comme indiqué dans l'article de T.R. Chen et al., "Phase locked InGaAsP laser array with diffraction coupling", Appl. Phys. Lett., vol. 43, n° 2, 1983, pp 136-137 ; par couplage Y comme décrit dans l'article de M. Taneya et al., "Phased array with the "YY" shaped symmetrically branching waveguide", Jap. J. Appl. Phys., vol. 25, n° 6, 1986, pp L432-L434 et par onde évanescente comme indiqué dans l'article de D.R. Scifres et al., "Phase locked semiconductor laser array", Appl. Phys. Lett., vol. 33, n° 12, 1978, pp 1015-1017.

Cette dernière solution est la plus étudiée pour des raisons de simplicité et de reproductibilité.

Si ces diodes lasers possèdent n rubans, elles possèdent aussi n modes de propagation comme décrit dans l'article de E. Kapon et al., "Supermode analysis of phase-locked arrays of semiconductor lasers", Opt. Lett., vol. 10, n° 4, 1984, pp 125-127 et dans l'article de J.K. Butler et al., "Coupled mode analysis of phase locked injection laser arrays", Appl. Phys. Lett., vol. 44, n° 3, 1984, pp 293-295.

Chaque mode a une répartition de champ électrique et une constante de propagation propre. La partie réelle de la constante de propagation détermine le spectre d'oscillation Fabry Perot de la cavité laser alors que la partie imaginaire détermine le gain. Le mode fondamental dont l'émission de tous les rubans est en phase est le plus intéressant a priori puisqu'il est le seul à avoir un lobe axial dans le champ lointain. Malheureusement, dans cette structure multirubans, le gain du mode augmente avec son ordre V (V est relié au nombre de zéro du champ) ; le mode fondamental a donc le plus faible gain et le mode d'ordre le plus élevé est le premier à osciller au seuil. Cependant, comme ce dernier n'a pas un parfait recouvrement avec les porteurs, d'autres modes d'ordre supérieur vont osciller lorsque le courant d'injection augmente.

En champ lointain, tous ces modes oscillants sont caractérisés par des lobes symétriques par rapport à l'axe optique du laser ; à chaque mode correspond un angle hors de l'axe. Ceci explique l'émission de tels lasers dans deux lobes symétriques, non limités par la diffraction comme décrit dans les articles de S. Thaniyavarn, W. Dougherty, "Generation of a single lobe radiation pattern from a phased array laser using a near contact variable phase shift zone plate", Elect. Lett., vol. 23, n° 1, 1987, pp 5-7 et de G.C. Dente et al., "Phase and spatial coherence measurements on diode arrays : comparison to supermode theory", Appl. Phys. Lett., vol. 51, n° 1, 1987, pp 9-11. Ce diagramme d'émission varie aussi avec le courant d'injection de la puissance optique.

Pour pallier à ce problème, différentes répartitions des rubans ont été utilisées pour obtenir une émission monolobe. Elles sont basées soit sur une répartition non uniforme du gain comme décrit dans l'article C.P. Lindsey et al., "Single contact tailored gain phased array of semiconductor lasers", Appl. Phys. Lett., vol. 45, n° 7, 1984, pp 722-724 ; du couplage entre rubans comme décrit dans l'article de D.E. Ackley et al., "Phase locked injection laser arrays with variable stripe spacing", IEEE J. Quantum Elect., vol. QE-22, n° 12, 1986, pp 2204-2212, soit sur un couplage en Y entre rubans comme enseigné dans l'article de D.F. Welch et al., "In phase-emission from index guided laser array up to 400 mW", Elect. Lett., vol. 22, n° 6, 1986, pp 293-294.

Une autre solution est basée sur l'hypothèse d'une oscillation du mode d'ordre le plus élevé dans la cavité laser, celui-ci ayant chaque ruban en opposition de phase par rapport à chacun de ses voisins ; un déphasage de π tous les deux rubans permet de les remettre tous en phase et d'obtenir une émission monolobe. Ceci peut être fait soit par déphasage dans la cavité laser comme décrit dans l'article de D.E. Ackley et al., "Phase locked injection laser arrays with integrated phase shifters", RCA review, vol. 44, 1983, pp 625-633 soit par dépôt d'un diélectrique sur l'une des faces clivées et attaque sélective comme enseigné dans l'article de M. Matsumoto et al., "Single lobed far field pattern operation in a phased array with an integrated phase shifter", Appl. Phys. Lett., vol. 50, n° 22, 1987, pp 1541-1543.

Cependant, dans toutes ces structures, aucune émission monolobe uniaxiale de forte puissance n'a pu être obtenue.

On connaît aussi des structures hybrides dans lesquelles un déphasage de r tous les deux rubans est réalisé avec un réseau de déphasage placé dans le champ proche du laser comme décrit dans l'article de M. Taneya et al., "Stable quasi 0° phase mode operation in a laser array diode nearly aligned with a phase shifter", Appl. Phys. Lett., vol. 50, n° 13, 1987, pp 783-785 ou dans l'article de S. Thaniyavarn, Topical Meeting on Semiconductor Lasers "Summaries of papers presented at the Semiconductor Lasers Topical Meeting", 10-11 février 1987, New Mexico, pages 158-161 ou un réseau de déphasage placé dans le plan image du laser grâce à un système optique comme enseigné dans l'article de J.R. Heidel et al., "Use of a phase corrector plate to generate a single-lobed phased array far field pattern", IEEE J. of Quantum Elect., vol. QE-22, n° 6, 1986, pp 749-752.

Pour avoir un déphasage de $\pi$, on doit avoir une différence d'épaisseur $h = (p + 1/2)\lambda/(n-1)$, p étant un entier, $\lambda$ la longueur d'onde de l'émission laser et n l'indice du matériau dans lequel est réalisé le réseau de déphasage.

Cependant, le mode d'ordre le plus élevé n'étant pas le seul à osciller dans la cavité laser, l'émission en sortie du réseau de déphasage n'est pas monolobe. Cette émission de sortie va dépendre de plus, du courant injecté.

Par ailleurs, il est connu d'utiliser une cavité externe associée à une diode laser multi-rubans, présentant une réflection selon l'axe optique. Une telle structure est décrite dans J. Yaeli et al., "Array mode selection utilizing an external cavity configuration", Appl. Phys. Lett., vol. 47, n° 2, 1985, pp 89-91.

A l'intérieur de la cavité, la face clivée de la diode du laser est traitée antireflet pour que l'oscillation ait lieu dans la cavité externe. Un filtre spatial dans le plan de Fourier d'une lentille permet de sélectionner le mode fondamental du laser. Cependant, l'efficacité quantique externe du dispositif est diminuée par rapport à la diode laser seule car le mode fondamental a un moins bon recouvrement avec le profil de gain que les modes d'ordre élevés qui existent naturellement dans la diode laser libre. De plus, à partir d'une certaine puissance optique, le mode d'ordre le plus élevé commence à osciller dans la diode laser seule à cause de la réflectivité résiduelle de la face laser intracavité ; ceci limite la puissance accessible dans le lobe central.

Une structure équivalente a été réalisée avec une structure réfléchissante localisée servant à la fois de miroir et de filtre spatial (voir article de C. Chang-Hasnain et al., 'Diffraction limited emission from a diode laser array in an apertured graded index lens external cavity", Appl. Phys. Lett., vol. 49, n°-11, 1986, pp 614-616.

Une réflexion hors de l'axe est aussi connue. Elle permet de faire osciller un mode d'ordre plus élevé dans la cavité ; celui-ci a alors un meilleur recouvrement avec le profil de gain que le mode fondamental. Une bonne efficacité quantique externe ainsi qu'une moindre importance de la réflectivité de la face laser intracavité peuvent être ainsi obtenues. Un tel dispositif est décrit dans C.J. Chang-Hasnain et al., "High power with high efficiency in a narrow single lobed beam from a diode laser in an external cavity", Appl. Phys. Lett., vol. 50, n° 21, 1987, pp 1465-1467.

Ce dispositif permet l'obtention d'une émission monolobe hors de l'axe optique.

Puisque chaque mode a son propre spectre d'oscillation Fabry Perot, on peut sélectionner un mode par une contre-réaction spectralement sélective. Cela peut être réalisé par un réseau comme décrit dans J.E. Epler et al., "Far field supermode patterns of a multiple stripe quantum well heterostructure laser operated ($\sim$7330 Å, 300 K) in an external grating cavity", Appl. Phys. Lett., vol. 45, n° 4, 1984, pp. 406-408. Cependant, à longueur d'onde donnée, le nombre de modes oscillants augmente avec la puissance optique émise. Le mode fondamental est alors le plus instable.

Le blocage d'un laser par injection d'un autre laser est aussi connu. L'injection de puissance optique d'un laser (laser maître) dans le laser de puissance (laser esclave) permet d'augmenter, dans ce dernier, le gain des modes les plus proches en profil et en fréquence d'émission de celui du laser maître. Si le mode du laser maître est monomode transverse et longitudinal, on peut sélectionner un mode dans le laser esclave qui est alors monofréquence.

Une puissance de 500 mW a ainsi été obtenue dans un lobe hors de l'axe ainsi que 150 mW dans une fibre optique monomode comme décrit dans l'article de L. Goldberg, J.F. Weller, "Injection locking and single-mode fiber coupling of 40-element laser diode array", Appl. Phys. Lett., vol. 50, n° 24, 1987, pp 1713-1715. Cependant, sous modulation, soit du laser maître, soit du laser esclave, la fréquence d'émission de l'un ou l'autre varie, ce qui change le mode sélectionné et donc l'angle hors de l'axe d'émission.

Une structure d'autoblocage du laser maître a été récemment démontrée dans l'article de L. Goldberg, J.F. Weller, "Single lobe operation of a 40-element laser array in an external ring laser cavity", Appl. Phys. Lett., vol. 51, n° 12, 1987, pp 871-872, grâce à une structure en anneau. La sensibilité d'une telle structure à la modulation reste importante.

Aussi, l'invention a pour objet un procédé et un dispositif pour améliorer la directivité de l'émission d'une diode laser solide permettant de remédier aux différents inconvénients décrits ci-dessus. L'invention est basée sur une utilisation d'une cavité externe particulière couplée à une diode à rubans multiples comme amplificateur. Selon l'invention, une émission monolobe axiale est obtenue avec une bonne efficacité quantique externe grâce à l'amplification du mode d'ordre le plus élevé dans la diode laser. De plus, l'ingérence de la réflectivité résiduelle de la face laser intracavité est diminuée.

Un premier objet de l'invention est un procédé pour améliorer l'efficacité de conversion et la directivité de l'émission d'une diode laser solide de type à rubans multiples, caractérisé en ce qu'il consiste à forcer l'amplification dans ladite diode de son mode d'ordre le plus élevé et donc de gain le plus fort, en lui couplant, avec un déphasage de $\pi$ entre deux rubans adjacents, une cavité externe de conversion agencée pour osciller, entre une première et une seconde extrémités, la seconde extrémité réfléchissant le mode fondamental de la diode, et ainsi assurer en sortie une émission monolobe axiale.

Un second objet de l'invention est un dispositif pour améliorer l'efficacité de conversion et la directivité de l'émission d'une diode laser solide de type à rubans multiples, caractérisé en ce qu'il comprend essentiellement une cavité externe couplée à la face intracavité de la diode via un déphaseur de π entre deux rubans adjacents et fermée par des moyens de réflexion partielle et localisée agencés pour qu'ils ne réfléchissent que le mode fondamental de la diode et ainsi permettre en sortie une émission monolobe axiale.

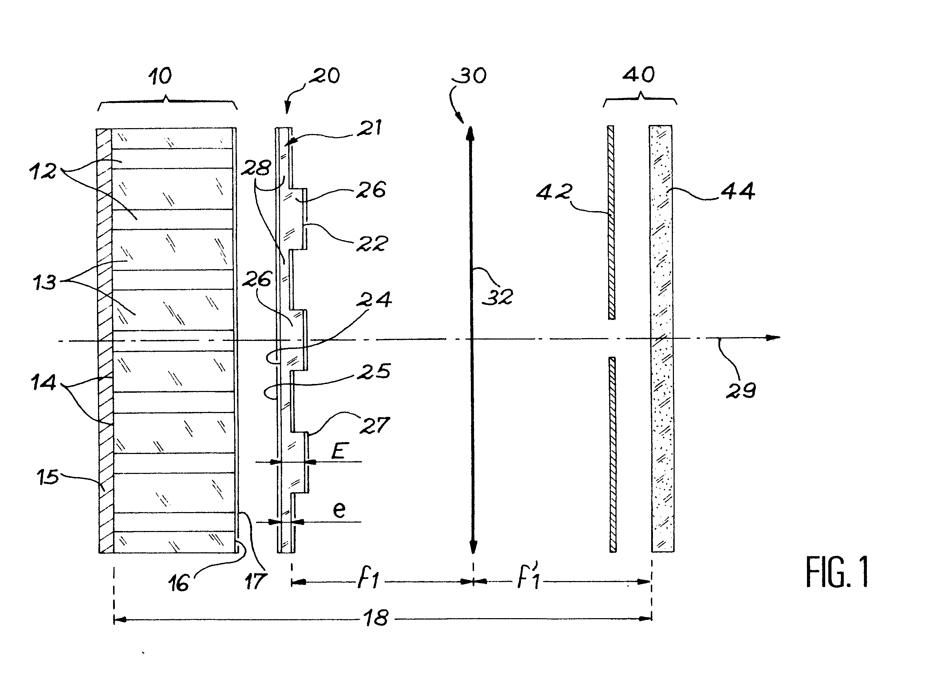

La description qui suit donnée à titre illustratif et non limitatif, se réfère aux figures 1-3 annexées montrant en vue de dessus, trois modes de réalisation du dispositif selon l'invention.

Sur la figure 1, on a représenté une diode laser semi-conductrice solide, de référence générale 10, comportant plusieurs rubans parallèles 12, métallisés, séparés par des zones non pompées 13. Les rubans 12 font 5 μm de large.

Pour des diodes lasers émettant entre 800 et 900 nm, la couche active sous-jacente aux rubans 12 et le substrat sont en GaAs intentionnellement non dopé et les couches de confinement en $Ga_{1-x}Al_xAs$ dopé n ou p, avec $0 < x \leq 1$ (x=0,3 ou 0,5 par exemple). Pour des diodes lasers émettant entre 1300 et 1650 nm, la couche active sous-jacente aux rubans 12 est en $Ga_{1-x}InAs_{1-y}P_y$, avec $0 < x \leq 1$ et $0 < y \leq 1$ avec x et y accordés sur la longueur d'émission voulue, les couches de confinement et le substrat en InP.

La couche active a une épaisseur de 100 nm environ et les couches de confinement de 1000 nm.

Cette diode 10 comporte une face laser clivée extracavité 14 pourvue d'un revêtement 15 hautement réfléchissant par exemple en $SiO_2$ recouvert d'un métal. La face intracavité de la diode, parallèle à la face clivée 14 porte la référence 16 et est revêtue d'un matériau 17 antireflet par exemple du SiO ou $Si_3N_4$. Le pompage optique est assuré électriquement et de façon connue en appliquant sur les rubans 12 un potentiel de quelques volts par rapport au potentiel de référence appliqué au substrat.

Selon l'invention, on couple la diode laser 10 à une cavité externe de conversion 18 avec un déphasage de π entre deux rubans adjacents 12, assuré par un déphaseur 20 du type réseau de déphasage. Ce déphaseur, dans un premier mode de réalisation, est placé dans le champ proche de la diode laser 10, c'est-à-dire à proximité de la face intracavité 16 de la diode. Le réseau 20 de déphasage est une couche de matériau 21 présentant en alternance deux épaisseurs e et E différant de $h = (p+1/2)\lambda/(n-1)$ où p est un entier positif, λ la longueur d'onde du rayonnement émis par la diode 10 et n l'indice de réfraction du matériau 21. Ce dernier peut être du $SiO_2$ avec n = 1,5, e = 100 nm et E = 185 nm pour une diode laser émettant à 850 nm. La largeur des zones 26 les plus épaisses est égale à celle des zones les plus fines 28. Le pas du réseau est par exemple de 20 μm. On peut aussi utiliser en variante un réseau d'indice.

Afin d'éviter toute réflexion partielle intermédiaire de la lumière produite par la diode 10, les faces arrière 22 et avant 24 du déphaseur 20 sont recouvertes respectivement d'un revêtement 25 et 27 antireflets tels que ceux classiquement utilisés sur du verre.

Selon l'invention, la cavité laser externe 18 est agencée pour osciller, entre l'extrémité 14 ou face clivée de la diode et l'extrémité de sortie 40, avec uniquement réflexion du mode fondamental de la diode 10 à l'extrémité 40, et assurer ainsi à la sortie 40 une émission 29 monolobe et selon l'axe de la cavité. A cet effet, et selon un premier mode de réalisation (figure 1), on utilise une optique de focalisation 30 telle qu'un objectif, une simple lentille convergente 32 ou une lentille GRIN dont les plans de Fourier (plans objet et image) coïncident d'une part avec le réseau de déphasage 20 et d'autre part avec l'extrémité de sortie 40 de la cavité. Les références f1 et f'1 indiquent les distances focales objet et image de la lentille 32.

La sélection du mode fondamental de la diode 10 est assurée par un filtre spatial 42 placé à l'extrémité 40 de la cavité. Un miroir 44 à réflexion partielle est placé en aval du filtre 42. Il permet de réfléchir une partie de l'émission laser en vue de son amplification ainsi que la sortie de l'émission 29.

Dans le plan de Fourier image de la lentille 32, le filtre spatial 42 sélectionne le mode fondamental de la diode laser 10. Ce mode fondamental se propageant en retour de la droite vers la gauche, est transformé dans le mode d'ordre le plus élevé par le réseau de déphasage 20 ; ce mode est alors injecté dans la diode laser 10, réfléchi sur la face laser clivée 14 possédant le traitement réfléchissant 15 et se propage à nouveau de la gauche vers la droite. Ce mode sort de la diode laser 10 par la face 16 traitée avec le matériau antireflet 17 et est transformé en mode fondamental par le réseau de déphasage 20 ; ce mode fondamental est ensuite réfléchi dans le plan de Fourier image de la lentille 32 et l'oscillation se poursuit.

L'avantage d'un tel dispositif laser est une émission monolobe axiale avec amplification du mode d'ordre le plus élevé dans la diode laser qui a le plus fort gain. Ceci a plusieurs avantages : une efficacité quantique externe meilleure que celle obtenue par amplification directe du mode fondamental et une moindre influence de la réflectivité résiduelle de la face intracavité 16 de la diode laser 10.

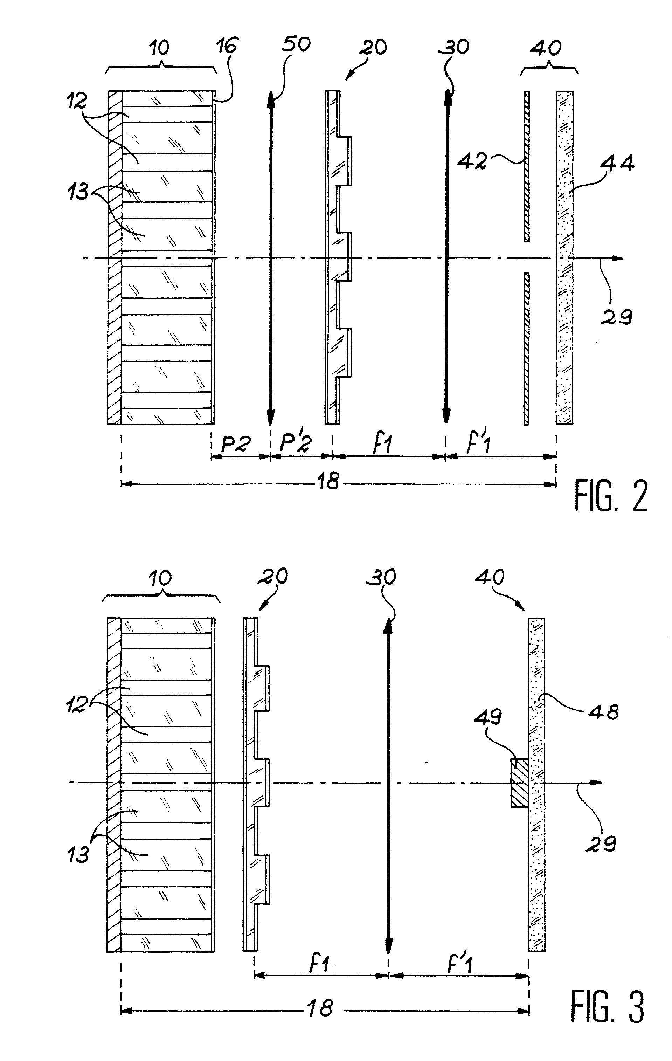

Selon l'invention, il est possible, comme représenté sur la figure 2 de réaliser le déphasage de π de l'émission laser issue de la diode en plaçant le réseau de déphasage 20 dans le plan image d'une optique de focalisation 50 telle qu'une lentille, le plan objet de cette lentille 50 étant alors confondu avec la face intracavité 16 de la diode ; les références $P_2$ et $P'_2$ symbolisent les distances focales objet et image de la lentille 50.

Il est aussi possible, comme représenté sur la figure 3, de remplacer le filtre spatial 42 et le miroir 44 semiréfléchissant associé par une structure à réflexion partielle localisée constituée par exemple par un matériau absorbant 48 revêtu en son centre d'une plage 49 réalisée en un matériau partiellement réfléchissant tel qu'un empilement de diélectrique.

D'autres modifications des éléments optiques de la cavité externe 18 ainsi que d'autres agencements de ces éléments peuvent être envisagés sans pour autant sortir du cadre de l'invention. En particulier, les modes de réalisation représentés sur les figures 2 et 3 peuvent être combinés.

## Revendications

1. Procédé pour améliorer l'efficacité de conversion et la directivité de l'émission d'une diode laser solide (10) de type à rubans multiples (12), caractérisé en ce qu'il consiste à forcer l'amplification dans ladite diode de son mode d'ordre le plus élevé et donc de gain le plus fort, en lui couplant, avec un déphasage de $\pi$ entre deux rubans (12) adjacents assuré par un déphaseur (20), une cavité externe de conversion (18) agencée pour osciller, entre une première et une seconde extrémités (14, 40), le mode fondamental de la diode (10) étant réfléchi à la seconde extrémité, et ainsi assurer en sortie une émission monolobe axiale (29).

2. Procédé selon la revendication 1, caractérisé en ce que le couplage de la diode à la cavité externe (18) est assuré de manière à éviter toute réflexion partielle intermédiaire.

3. Procédé selon la revendication 1 ou 2, caractérisé en ce que la première extrémité (14) de la cavité externe possède une haute réflexion alors que la seconde extrémité (40) possède une réflexion partielle et localisée.

4. Procédé selon l'une quelconque des revendications précédentes, caractérisé en ce que l'on utilise dans la cavité externe des moyens de focalisation (30) dont les plans de Fourier sont confondus avec les plans du déphaseur (20) et de la seconde extrémité (40).

5. Procédé selon l'une quelconque des revendications précédentes, caractérisé en ce que l'on utilise la face clivée (14) de la diode comme première extrémité.

6. Dispositif pour améliorer l'efficacité de conversion et la directivité de l'émission d'une diode laser solide (10) de type à rubans multiples (12), caractérisé en ce qu'il comprend essentiellement une cavité externe (18) couplée à la face intracavité (16) de la diode via un déphaseur (20) de $\pi$ entre deux rubans (12) adjacents et fermée par des moyens (42, 44, 49) de réflexion partielle et localisée agencés pour qu'ils ne réfléchissent que le mode fondamental de la diode et ainsi permettre en sortie une émission monolobe axiale.

7. Dispositif selon la revendication 6, caractérisé en ce que le déphaseur est un réseau de déphasage (20) formé d'une couche de matériau (21) présentant en alternance deux épaisseurs e et E différant de $h = (p + 1/2) \lambda/(n-1)$ où p est un entier, $\lambda$ la longueur d'onde du rayonnement émis par la diode et n l'indice de réfraction du matériau.

8. Dispositif selon la revendication 6 ou 7, caractérisé en ce que le déphaseur (20) est situé dans le champ proche de la face intracavité (16) de la diode ou dans son plan image grâce à une première optique de focalisation (50).

9. Dispositif selon l'une quelconque des revendications 6 à 8, caractérisé en ce que la face intracavité (16) de la diode et les deux faces (24, 6) du déphaseur (20) sont traitées avec des matériaux antireflets (25, 27).

10. Dispositif selon l'une quelconque des revendications 6 à 9, caractérisé en ce que la face clivée extracavité (14) de la diode est pourvue d'un revêtement (15) hautement réfléchissant.

11. Dispositif selon l'une quelconque des revendications 6 à 10, caractérisé en ce que l'extrémité (40) de la cavité externe opposée à la diode est pourvue d'un filtre spatial (42) et d'un miroir à réflexion partielle (44) ou d'une structure équivalente à réflexion partielle localisée (48).

12. Dispositif selon la revendication 11, caractérisé en ce que la cavité externe. inclut une seconde optique de focalisation (30) dont les plans de Fourier coïncident avec le déphaseur (20) et la structure de réflexion localisée (40) ou le miroir (44).

FIG. 1

EP 0 338 904 A1

FIG. 2

FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | TOPICAL MEETING ON SEMICONDUCTOR LASERS, "Summaries of papers presented at the Seniconductor Lasers Topical Meeting", Alberquerque, New Mexico, 10th - 11th février 1987, pages 158-161, Optical Society of America, Washinton, D.C., US; S. THANIYAVARN et al.: "Generation of a single-lobe radiation pattern from a phased-array laser using a near contact variable-phase-shift zone plate" * En entier * --- | 1,2,6-9 | H 01 S 3/23 H 01 S 3/08 H 01 S 3/19 |
| A | APPLIED OPTICS, vol. 26, no. 20, 15 octobre 1987, pages 4391-4399, Optical Society of America, New York, NY., US; J.R. LEGER et al.: "Coherent laser addition using binary phase gratings" * Paragraphes V,VI; figures 7,10 * --- | 1-12 | |
| D,A | APPLIED PHYSICS LETTERS, vol. 47, no. 2, 15 juillet 1985, pages 89-91, American Institute of Physics, New York, US; J. YAELI et al.: "Array mode selection utilizing an external cavity configuration" * Pages 89-90; figure 1 * --- | 1-3,6,9 ,11 | DOMAINES TECHNIQUES RECHERCHES (Int. Cl.4) H 01 S |
| D,A | IEEE JOURNAL OF QUANTUM ELECTRONICS, vol. QE-22, no. 6, juin 1986, pages 749-753, IEEE, New York, US; J.R. HEIDEL et al.: "Use of a phase corrector plate to generate a single-lobed phased array far field pattern" * Pages 749-750; figures 2,3 * --- -/- | 1,6-8 | |

Le présent rapport a été établi pour toutes les revendications

| Lieu de la recherche | Date d'achèvement de la recherche | Examinateur |
|---|---|---|
| LA HAYE | 06-07-1989 | GNUGESSER H.M. |

Office européen
des brevets

**RAPPORT DE RECHERCHE EUROPEENNE**

Numero de la demande

EP  89 40 1052

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | APPLIED PHYSICS LETTERS, vol. 50, no. 13, 30 mars 1987, pages 783-785, American Institute of Physics, New York, US; M. TANEYA et al.: "Stable quasi 0 degrees phase mode operation in a laser array diode nearly aligned with a phase shifter"<br>* Pages 783-784; figure 1 *<br>----- | 1,6,9, 10 | |
| | | | **DOMAINES TECHNIQUES RECHERCHES (Int. Cl.4)** |

Le présent rapport a été établi pour toutes les revendications

| Lieu de la recherche | Date d'achèvement de la recherche | Examinateur |
|---|---|---|
| LA HAYE | 06-07-1989 | GNUGESSER H.M. |

EPO FORM 1503 03.82 (P0402)